(19) **Europäisches Patentamt European Patent Office Office européen des brevets**

(11) **EP 4 422 380 B1**

(12) **EUROPEAN PATENT SPECIFICATION**

(45) Date of publication and mention of the grant of the patent:
**25.02.2026 Bulletin 2026/09**

(21) Application number: **22883211.9**

(22) Date of filing: **30.08.2022**

(51) International Patent Classification (IPC):
*H10N 30/87* (2023.01)    *H10N 30/857* (2023.01)
*H10N 30/06* (2023.01)    *B32B 7/023* (2019.01)
*B32B 7/025* (2019.01)    *B32B 27/00* (2006.01)
*H10N 30/045* (2023.01)

(52) Cooperative Patent Classification (CPC):
**H10N 30/857; B32B 7/023; B32B 7/025; B32B 27/00; C08J 7/0423; C08J 7/044; H10N 30/06; H10N 30/878;** C08J 2327/16; C08J 2433/02

(86) International application number:
**PCT/JP2022/032536**

(87) International publication number:
**WO 2023/067899 (27.04.2023 Gazette 2023/17)**

(54) **TRANSPARENT CONDUCTIVE PIEZOELECTRIC FILM, DEVICE, AND PRODUCTION METHOD FOR TRANSPARENT CONDUCTIVE PIEZOELECTRIC FILM**

TRANSPARENTER LEITFÄHIGER PIEZOELEKTRISCHER FILM, VORRICHTUNG UND HERSTELLUNGSVERFAHREN FÜR TRANSPARENTEN LEITFÄHIGEN PIEZOELEKTRISCHEN FILM

FILM PIÉZOÉLECTRIQUE CONDUCTEUR TRANSPARENT, DISPOSITIF ET PROCÉDÉ DE PRODUCTION POUR FILM PIÉZOÉLECTRIQUE CONDUCTEUR TRANSPARENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.10.2021 JP 2021173430**

(43) Date of publication of application:
**28.08.2024 Bulletin 2024/35**

(73) Proprietor: **Kureha Corporation**
**Chuo-ku**
**Tokyo 103-8552 (JP)**

(72) Inventors:
• **IMAJI, Makoto**
  **Tokyo 103-8552 (JP)**
• **YAMAGUCHI, Kei**
  **Tokyo 103-8552 (JP)**

(74) Representative: **Novagraaf Group**
**Chemin de l'Echo 3**
**1213 Onex / Geneva (CH)**

(56) References cited:
WO-A1-2017/170616    JP-A- 2002 120 311
JP-A- 2004 098 420    JP-A- 2017 074 792
JP-A- 2019 096 680    US-A1- 2017 033 276

## Description

## TECHNICAL FIELD

The present invention relates to a transparent conductive piezoelectric laminated film, a device, and a method of producing a transparent conductive piezoelectric film.

## BACKGROUND ART

Piezoelectric materials are materials that generate a voltage proportional to a pressure applied to the material, and deform when a voltage is applied, i.e., materials having a piezoelectric effect. Piezoelectric materials have a piezoelectric effect and thus are used in actuators, sensors, oscillation circuits or filter circuits in analog circuits, and the like. Furthermore, piezoelectric materials having transparency are useful, and depending on the application, a piezoelectric material having high transparency is particularly required.

Patent Document 1 describes a technique of suppressing the development of a color tone in a transparent conductive film using a transparent film base material having no piezoelectric properties.

Patent Document 2 describes a piezoelectric polymer layer with a Yellow Index of 4 or less without taking into account any electrodes.

Citation List

Patent Document

Patent Document 1: JP 2017-074792 A
Patent Document 2 : US 2017/0033279 A1

## SUMMARY OF INVENTION

Technical Problem

As a result of studies, the inventors have found a problem that a conductive piezoelectric film obtained by producing a piezoelectric film using a piezoelectric material having high transparency and laminating a transparent electrode thereon has transparency that is not sufficiently maintained.

It is an object of one aspect of the present invention to realize a transparent conductive piezoelectric film having transparency.

Solution to Problem

In order to solve the above-described problems, a transparent conductive piezoelectric laminated film according to claim 1 is provided.

In order to solve the above-described problems, one aspect of a method of producing a transparent conductive piezoelectric laminated film according to one aspect of the present invention is a method of producing a laminated film, in which a first transparent coating layer, a second transparent coating layer, and a transparent electrode layer are stacked in this order on at least one surface of a transparent piezoelectric film, the method including a first step of producing the transparent piezoelectric film forming a film having a refractive index of 1.30 or greater and less than 1.45, a second step of forming the first transparent coating layer having a refractive index of 1.60 or greater and less than 1.80 on at least one surface of the transparent piezoelectric film, a third step of forming the second transparent coating layer having a refractive index of 1.30 or greater and less than 1.50 on a surface of the first transparent coating layer, and a fourth step of forming the transparent electrode layer having a refractive index of 1.80 to 2.20 on a surface of the second transparent coating layer.

Advantageous Effects of Invention

According to one aspect of the present invention, it is possible to realize a transparent conductive piezoelectric film having transparency.

## BRIEF DESCRIPTION OF THE DRAWINGS

FIG. 1 illustrates a transparent conductive piezoelectric laminated film 11 according to one embodiment of the present invention.
FIG. 2 illustrates a transparent conductive piezoelectric laminated film 12 according to one embodiment of the present invention.

## DESCRIPTION OF EMBODIMENTS

One embodiment of the present invention will be described in detail below.

Transparent Conductive Piezoelectric Laminated Film A transparent conductive piezoelectric laminated film according to one embodiment of the present invention is a film in which a transparent electrode layer is provided on a piezoelectric film. The transparent conductive piezoelectric laminated film of the present embodiment has a piezoelectric constant $d_{31}$ of 10 pC/N to 40 pC/N and a total transmittance of 90% or greater. The transparent conductive piezoelectric laminated film has excellent piezoelectric properties, transparency, and conductivity, and can be suitably used in a wide range of devices.

Piezoelectric Constant

It is only required that the piezoelectric constant $d_{31}$ of the transparent conductive piezoelectric laminated film of the present embodiment is 10 pC/N or greater, preferably 14 pC/N or greater, and more preferably 18 pC/N or greater. Furthermore, it is only required that the piezoelectric constant $d_{31}$ of the transparent conductive piezoelectric laminated film is 40 pC/N or less, and the piezoelectric constant $d_{31}$ may be 35 pC/N or less or 30 pC/N or less. Such a piezoelectric constant is achieved by the piezoelectric film included in the transparent conductive piezoelectric laminated film.

The piezoelectric constant $d_{31}$ indicates a displacement of the film in a lateral direction (a direction perpendicular to the direction of the electric field) relative to an applied voltage. In order to impart sufficient piezoelectric properties to the transparent conductive piezoelectric laminated film, it is preferable that the piezoelectric constant $d_{31}$ is specifically not below a lower limit. When the piezoelectric constant $d_{31}$ is greater, the displacement relative to the applied voltage increases, which is particularly preferable for applications in an actuator. On the other hand, the piezoelectric constant $d_{31}$ is 40 pC/N or less, from the viewpoint of realizing such a piezoelectric constant by the transparent conductive piezoelectric laminated film.

The transparent conductive piezoelectric laminated film having such a piezoelectric constant $d_{31}$ is expected to be applied to a wide range of devices. For example, the transparent conductive oiezoelectric laminated film is expected to be applied to sensors such as pressure sensors and vibration sensors, switches, energy harvesting elements, actuators, touch panels, haptic devices, speakers, and microphones. The transparent conductive piezoelectric laminated film in which the range of the piezoelectric constant $d_{31}$ is in the above range is particularly suitable for use in an actuator.

Total Transmittance

In the transparent conductive piezoelectric laminated film, it is only required that the total transmittance is 90% or greater, and the total transmittance is preferably 91% or greater, and more preferably 92% or greater. When the total transmittance is in the above-mentioned range, the transparent conductive piezoelectric laminated film can be suitably used in a device requiring transparency. For example, when the transparent conductive piezoelectric laminated film is utilized in a display of any device, the total transmittance in the above-mentioned range is preferable in that the transparent conductive piezoelectric laminated film is transparent and thus does not hinder the display screen of the display. The transparent conductive piezoelectric laminated film may have a total transmittance of 97% or less, as long as a desired effect is sufficiently obtained in the case described above, but the total transmittance is not particularly limited. The total transmittance is preferably as close to 100% as possible. Hereinafter, in the present specification, the term "transparency" refers to an optical property evaluated by a total light transmissivity, and "transparent" or "high transparency" refers to a state in which the total light transmissivity is 90% or greater.

Transparent Electrode Layer

The transparent conductive piezoelectric laminated film includes a transparent electrode layer. The transparent electrode layer is a structure that is transparent, conductive, and extends in a plane. The shape of the transparent electrode layer in a plan view may be appropriately selected depending on the application of the transparent conductive piezoelectric laminated film. The transparent electrode layer will be described in detail in "Specific Examples of Transparent Conductive Piezoelectric Laminated Film".

The surface resistance value of the transparent electrode layer of the transparent conductive piezoelectric laminated film may be determined according to an application. For example, the transparent conductive piezoelectric laminated film may have a surface resistance value of 300 Ω/sq or greater, 400 Ω/sq or greater, and further, 500 Ω/sq or greater. The surface resistance value may be less than 1700 Ω/sq. When the surface resistance value of the transparent electrode layer is in the above-mentioned range, the transparent conductive piezoelectric laminated film can be used as a film having conductivity in any device. The surface resistance value may be less than 1000 Ω/sq. When the surface resistance value is in the above-mentioned range, the transparent conductive piezoelectric laminated film can be suitably used in a device such as an actuator, for example.

Specific Examples of Transparent Conductive Piezoelectric Laminated Film

In order to obtain the transparent conductive piezoelectric laminated film described above, the transparent conductive piezoelectric laminated film may be a laminated film formed by stacking a plurality of layers of any type. The transparent conductive piezoelectric laminated film is a laminated film having a structure in which a first transparent coating layer, a second transparent coating layer, and the transparent electrode layer are stacked in this order on at least one surface side of a transparent piezoelectric film.

In the present embodiment, the expression "stacked in this order" refers to a state in which the layers are arranged adjacent to each other in the mentioned order in a laminate including the layers described above.

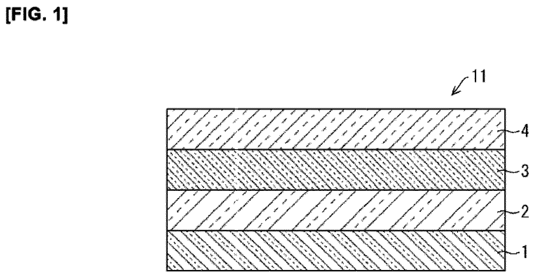

FIG. 1 illustrates a transparent conductive piezoelectric laminated film 11 as an example of the transparent conductive piezoelectric film. The transparent conductive piezoelectric film 11 is a laminated film in which a first transparent coating layer 2, a second transparent coating layer 3, and a transparent electrode layer 4 are stacked in this order on one surface of a transparent piezoelectric film 1. The transparent conductive piezoelectric film 11 is not limited to the configuration illustrated in FIG. 1, and may further include another layer structure.

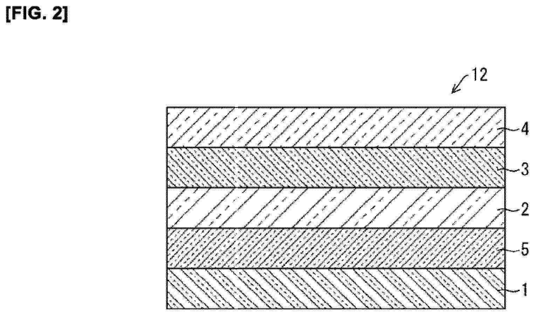

The transparent conductive piezoelectric laminated film 11 may be a transparent conductive piezoelectric laminated film in which the transparent piezoelectric laminated film 1 and the first transparent coating layer 2 are stacked with the third transparent coating layer 5 sandwiched therebetween. That is, the transparent conductive piezoelectric laminated film 11 may be a transparent conductive piezoelectric laminated film that includes the third transparent coating layer 5 between the transparent piezoelectric film 1 and the first transparent coating layer 2. Such a transparent conductive piezoelectric laminated film is illustrated as a transparent conductive piezoelectric laminated film 12 in FIG. 2. The transparent conductive piezoelectric laminated film 12 is a laminated film in which the third transparent coating layer 5, the first transparent coating layer 2, the second transparent coating layer 3, and the transparent electrode layer 4 are stacked in this order on one surface of the transparent piezoelectric film 1.

For example, in the transparent conductive piezoelectric laminated film 11, the transparent piezoelectric film 1 has a refractive index of 1.30 or greater and less than 1.45, the first transparent coating layer 2 has a refractive index of 1.60 or greater and less than 1.80, the second transparent coating layer 3 has a refractive index of 1.30 to 1.50, and the transparent electrode layer 4 has a refractive index of 1.80 to 2.20. When the refractive index of each layer is in the above-mentioned range, the transparent conductive piezoelectric laminated film 11 can be configured as a transparent conductive piezoelectric laminated film having a total transmittance of 90% or greater.

When the transparent conductive piezoelectric laminated film 11 is the transparent conductive piezoelectric laminated film 12, the refractive index of the third transparent coating layer 5 may be 1.45 or greater and less than 1.60. The transparent conductive piezoelectric laminated film 12 includes the third transparent coating layer 5, and thus the transparency can be improved.

In the present embodiment, the term "refractive index" refers to a refractive index at a wavelength of 589 nm.

The refractive indices of the first transparent coating layer 2 and the second transparent coating layer 3 are measured in conformity with JIS K7142. Specifically, each experimentally prepared coating layer is irradiated with measurement light having a wavelength of 589 nm and each layer is measured three times at 25.0 $\pm$ 1.0°C using an Abbe refractometer. The average of the measured values is calculated to obtain the refractive index.

In order to calculate the refractive index of the transparent electrode layer 4, psi ($\Psi$) and delta ($\Delta$) are measured by using a multiple-angle incidence high-speed spectroscopic ellipsometer (M-2000, available from J. A. Woollam Co.Inc.). The refractive index at a wavelength of 589 nm is calculated from psi ($\Psi$) and delta ($\Delta$).

The refractive index of the transparent piezoelectric film 1 is measured in conformity with ASTM D542.

In the transparent conductive piezoelectric laminated film 11, the thickness of the transparent electrode layer 4 is 5 nm or greater and less than 20 nm. When the thickness of the transparent electrode layer 4 is in the above-mentioned range, suitable resistance and transparency can be imparted to the transparent conductive piezoelectric laminated film 11.

Each layer in the transparent conductive piezoelectric laminated film 11 and the transparent conductive piezoelectric laminated film 12 will be described in detail below. In the transparent conductive piezoelectric laminated film 11, the refractive index of each layer is set to an "more preferable" range described later, and thus it is possible to obtain a transparent conductive piezoelectric laminated film having higher transparency.

Transparent Piezoelectric Film 1 The transparent piezoelectric film 1 included in the transparent conductive piezoelectric laminated film 11 refers to a film that has piezoelectric properties and is transparent. In the transparent piezoelectric film 1, the term "transparent" refers to a state in which the film has a total transmittance of 80% or greater. For example, the total transmittance of the transparent piezoelectric film may be 80% or greater, and is preferably 85% or greater, and more preferably 90% or greater.

For example, the refractive index of the transparent piezoelectric film 1 is 1.30 or greater and less than 1.45. It is only required that the refractive index of the transparent piezoelectric film 1 is in this range. However, the refractive index is preferably 1.34 or greater and more preferably 1.36 or greater. Furthermore, the refractive index of the transparent piezoelectric film 1 is preferably 1.44 or less and more preferably 1.43 or less.

In the present embodiment, the transparent piezoelectric film 1 is a film made of a resin. The resin in the present embodiment may be any resin, as long as the film has piezoelectric properties represented by the piezoelectric constant $d_{31}$, and may be one type of resin or a combination of two or more types of resins. Examples of the resin satisfying the conditions described above include fluororesins, polyamide 11, cellulose, polyurethane, and polyurea.

Among the resins described above, the fluororesins are preferable. When the transparent piezoelectric film is made of a fluororesin, it is possible to obtain a transparent conductive piezoelectric film having excellent transparency and piezoelectric properties represented by the piezoelectric constant $d_{31}$. In the present embodiment, the expression "made of a fluororesin" in the embodiment means that the fluororesin is a main component in a composition constituting the transparent piezoelectric film. The expression that "the fluororesin is a main component" means that the fluororesin is the largest component in the composition. A content of the fluororesin in the composition is preferably 51 mass% or greater, more preferably 80 mass% or greater, and particularly preferably 100 mass%. That is, the transparent piezoelectric film 1 is particularly preferably a film made of a fluororesin.

Among the fluororesins, a vinylidene fluoride resin is preferable. Examples of the vinylidene fluoride resin include a homopolymer of vinylidene fluoride and a copolymer of vinylidene fluoride. The content of the structural unit derived from a monomer other than vinylidene fluoride in the copolymer of vinylidene fluoride may be appropriately determined within a range in which properties specific to the application of the transparent piezoelectric film can be obtained.

Examples of the monomer other than vinylidene fluoride in the copolymer of vinylidene fluoride include a hydrocarbon-based monomer and a fluorine compound. Examples of the hydrocarbon-based monomer include fluoromonomers such as vinyl fluoride (VF), trifluoroethylene (TrFE), tetrafluoroethylene (TeFE), hexafluoropropene (HFP), 1-chloro-1-fluoro-ethylene (1,1-CFE), 1-chloro-2-fluoro-ethylene (1,2-CFE), 1-chloro-2,2-difluoroethylene (CDFE), chlorotrifluoroethylene (CTFE), trifluorovinyl monomer, 1,1,2-trifluorobutene-4-bromo-1-butene, 1,1,2-trifluorobutene-4-silane-1-butene, perfluoroalkyl vinyl ether, perfluoromethyl vinyl ether (PMVE), perfluoropropyl vinyl ether (PPVE), perfluoroacrylate, 2,2,2-trifluoroethyl acrylate, and 2-(perfluorohexyl)ethyl acrylate; and hydrocarbon-based monomers such as ethylene, propene, maleic anhydride, vinyl ether, vinyl ester, allyl glycidyl ether, acrylic acid-based monomer, methacrylic acid-based monomer, and vinyl acetate. Among these, trifluoroethylene, tetrafluoroethylene, and hexafluoropropene are preferable as the monomer other than vinylidene fluoride in the copolymer.

For example, the vinylidene fluoride copolymer may be a binary copolymer such as a vinylidene fluoride copolymer (VDF/TrFE) obtained by copolymerization of vinylidene fluoride and trifluoroethylene, a vinylidene fluoride copolymer (VDF/HFP) obtained by copolymerization of vinylidene fluoride and hexafluoropropene, and a vinylidene fluoride copolymer (VDF/TeFE) obtained by copolymerization of vinylidene fluoride and tetrafluoroethylene. The binary copolymer preferably has a mixing ratio of vinylidene fluoride to the comonomer from 50:50 to 90:10. For example, a vinylidene fluoride copolymer (VDF/TeFP) may be obtained by copolymerization of vinylidene fluoride and tetrafluoroethylene at a mixing ratio of 80:20. Furthermore, the vinylidene fluoride copolymer may be a ternary copolymer such as a vinylidene fluoride copolymer (VDF/TFE/HFP) obtained by copolymerization of vinylidene fluoride, trifluoroethylene, and hexafluoropropene at a mixing ratio of 40:40:20.

In the present embodiment, a homopolymer of vinylidene fluoride and a copolymer of vinylidene fluoride and tetrafluoroethylene are preferably used.

The transparent piezoelectric film in the present embodiment may contain various additives as long as the effect of the present embodiment can be achieved. The additive may be one type of additive or multiple types of additives, and examples thereof include a plasticizer, a lubricant, a crosslinking agent, a UV absorber, a pH controlling agent, a stabilizer, an antioxidant, a surfactant, and a pigment.

The thickness of the transparent piezoelectric film 1 in the present embodiment can be appropriately determined from a range in which the effect of the present embodiment can be achieved, depending on the application of the transparent conductive piezoelectric laminated film 11. When the thickness of the transparent piezoelectric film 1 is too small, the mechanical strength of the film may be insufficient. When the thickness of the film is too large, the effect of the film may plateau or the transparency may be insufficient, and it may be difficult to use the transparent piezoelectric film 1 in an optical application. From this viewpoint, the thickness of the transparent piezoelectric film 1 may be 10 $\mu$m or greater, and is preferably 20 $\mu$m or greater and more preferably 30 $\mu$m or greater. Furthermore, the thickness of the transparent piezoelectric film 1 may be 200 $\mu$m or less, and is preferably 120 $\mu$m or less and more preferably 70 $\mu$m or less.

Transparent Electrode Layer 4

The transparent electrode layer 4 in the present embodiment is a layered electrode stacked on the second transparent coating layer 3.

The transparent electrode layer 4 in the present embodiment has a structure that extends in a plane, is conductive, and sufficiently transparent, and can also be referred to as a transparent conductive layer. Even if a material constituting the transparent electrode layer 4 is not transparent, it is only required that the transparent electrode layer 4 exhibits sufficient transparency in a structure in which the transparent electrode layer 4 can exhibit its function. For example, the transparent electrode layer 4 may include a conductive component or composition having high transparency, or may include a conductive material not having transparency, but have a very thin or very fine structure capable of exhibiting sufficient transparency.

The transparent electrode layer 4 may be formed on a transparent substrate and bonded to the second transparent coating layer 3 together with the substrate. It is only required that the transparent electrode layer 4 is arranged on at least one surface side of the transparent piezoelectric film 1. When the first transparent coating layer 2 and the second transparent coating layer 3 are formed on both surface sides of the transparent piezoelectric film, it is only required that the transparent electrode layer 4 is arranged on the second transparent coating layer 3 on at least one side.

A material forming the transparent electrode layer 4 is not limited, and a metal oxide of at least one metal selected from the group consisting of In, Sn, Zn, Ga, Sb, Ti, Si, Zr, Mg, Al, Au, Ag, Cu, Pd, and W may be suitably used. As the metal oxide, ITO, zinc oxide, an antimony-tin composite oxide (ATO), or the like is preferably used, and ITO is particularly preferably used. The metal oxide may be doped with a metal atom indicated in the group described above, if necessary.

In order to avoid discoloration of the transparent piezoelectric film 1, it is necessary not to heat the transparent conductive piezoelectric laminated film 11 in the present embodiment at high temperatures. Therefore, when the material of the transparent electrode layer 4 is a metal oxide, the metal oxide may be amorphous. The fact that the transparent electrode layer 4 is made of an amorphous material can be confirmed by an image observed by using a transmission electron microscope. In the present specification, a material in which crystals other than fine crystals are not observed is referred to as amorphous, and a material in which crystals are grown to such an extent that crystal grains are observed is referred to as crystalline.

The amorphousness of the metal oxide in the transparent electrode layer 4 can be adjusted depending on whether a step of promoting crystallization, such as annealing after the transparent electrode layer 4 is formed, is implemented in the preparation of the transparent electrode layer 4, and the degree to which this step is implemented.

In one embodiment, the transparent electrode layer 4 is formed of an indium-tin composite oxide. In still another aspect, the transparent electrode layer 4 is formed of an indium-tin composite oxide, and is in a state where a peak of the indium-tin composite oxide is not detectable by X-ray diffraction. According to such a configuration, it is possible to provide the transparent electrode layer 4 that is amorphous and further has a refractive index in a suitable range.

The refractive index of the transparent electrode layer 4 is from 1.80 to 2.20, for example. The refractive index of the transparent electrode layer 4 is not limited, as long as the refractive index is in this range, and is preferably 1.83 or greater, and more preferably 1.85 or greater. Furthermore, the refractive index of the transparent electrode layer 4 is preferably 2.00 or less and more preferably 1.94 or less.

In particular, the transparent conductive piezoelectric laminated film including the transparent electrode layer 4 having a refractive index of 1.94 or less is a film produced without heating at high temperatures. Therefore, the transparency and the color tone of the transparent piezoelectric film 1 are not impaired by a high-temperature treatment, and a suitable transparent conductive piezoelectric laminated film can be obtained. Especially, a transparent conductive piezoelectric laminated film including the transparent electrode layer 4 that is amorphous and has a refractive index of 1.94 or less is preferable.

On the other hand, when the material of the transparent electrode layer 4 is amorphous, this material layer 4 itself is a material having a yellow tone. The transparent conductive piezoelectric laminated film 11 including the transparent electrode layer 4 deposited tends to be a film having a color tone, even if other layers are transparent. However, similarly to the transparent conductive piezoelectric laminated film 11 according to one embodiment of the present invention, by adjusting the refractive index of each layer, it is possible to realize the transparent conductive piezoelectric laminated film 11 having suitable optical characteristics.

It is only required that the thickness of the transparent electrode layer 4 is 5 nm or greater. The thickness of the transparent electrode layer 4 is preferably 7 nm or greater and more preferably 8 nm or greater. When the thickness of the transparent electrode layer 4 is too small, the electrical resistance of the transparent conductive piezoelectric laminated film 11 may increase, and a discontinuous portion may be formed in the transparent electrode layer 4. When the thickness of the transparent electrode layer 4 is not less than the lower limit described above, it is possible to obtain the transparent conductive piezoelectric laminated film 11 as a continuous coating film having good conductivity with a resistance of less than 1700 Ω/sq.

It is only required that the thickness of the transparent electrode layer 4 is less than 25 nm. The thickness of the transparent electrode layer 4 is preferably less than 20 nm and more preferably less than 15 nm. When the thickness of the transparent electrode layer 4 is too large, the transparency may decrease, for example. When the thickness of the transparent electrode layer 4 does not exceed the upper limit described above, the transparency of the transparent conductive piezoelectric laminated film can be enhanced. The thickness of the transparent electrode layer 4 is determined by the following method in which the thickness is determined by observation of a cross section of the transparent conductive piezoelectric lamianted film 11.

The transparent conductive piezoelectric laminated film is embedded in an epoxy resin, and the epoxy resin mass is cut to expose a cross section of the transparent conductive piezoelectric laminated film. The exposed cross section of the transparent conductive piezoelectric laminated film is observed by using a scanning electron microscope ("SU3800", available from Hitachi High-Tech Corporation) under conditions including an acceleration voltage of 3.0 kV and a magnification of 50000 times, to measure the thicknesses of the coating layers and the transparent electrode layer in the transparent conductive piezoelectric laminated film.

In the measurement of the thicknesses of the coating layers and the transparent electrode layer, the thickness is measured at any two locations of each of the coating layers and the transparent electrode layer, and the average value of the measurement values obtained for each layer is used as the thickness of each layer. Under the observation conditions described above, an interface between the layers is observed and is a substantially smooth line. In this case, in the measurement of the thickness of each layer, the distance between the lines is measured.

As described above, the thickness of the transparent electrode layer 4 is important from the viewpoint of maintaining the conductivity and improving the transparency of the transparent conductive piezoelectric laminated film 11. Furthermore, by a preferable combination of refractive indices and thicknesses of the first transparent coating layer, the second transparent coating layer, the transparent electrode layer, and the third transparent coating layer which is optionally provided in the transparent conductive piezoelectric film 11, interface reflection between the layers is suitably adjusted to cancel out interface reflection, and the transparency is further improved.

First Transparent Coating Layer 2

The first transparent coating layer 2 in the present embodiment is a layer positioned between the transparent piezoelectric film 1 and the second transparent coating layer 3.

The refractive index of the first transparent coating layer 2 is 1.60 or greater and less than 1.80, for example. It is only required that the refractive index of the first transparent coating layer 2 is in this range. The refractive index of the first transparent coating layer 2 is preferably 1.63 or greater and more preferably 1.65 or greater. Furthermore, the refractive index of the first transparent coating layer 2 is preferably 1.75 or less and more preferably 1.72 or less.

The material of the first transparent coating layer 2 may be appropriately selected from any usable materials, as long as the material satisfies such a refractive index. The material may be an inorganic material or an organic material, and a mixed material of an inorganic material and an organic material, or a composite material thereof may be used. The material may be one type of material, a mixed material including two or more types of materials, and a composite material. In order to improve the transparency of the transparent conductive piezoelectric laminated film, it is preferable to use one type of material or a composite material further containing metal oxide particles described later. Further, the material of the coating layer may be a material of a hard coat layer. Examples of the material include a melamine resin, a urethane resin, a (meth)acrylic acid ester resin, a silane compound, and a metal oxide. The term "(meth)acrylic acid" is a generic term for acrylic acid and methacrylic acid, and means one or both of acrylic acid and methacrylic acid. In particular, the (meth)acrylic acid ester resin is preferable from the viewpoints of sufficient transparency, abundance of material types, and low raw material price.

Metal oxide particles may be added to the above-described materials to adjust the refractive index of the first transparent coating layer 2. The refractive index of the fine metal oxide particles is preferably 1.50 or greater.

Examples of the fine metal oxide particles include aluminum oxide, titanium oxide, zirconium oxide, zinc oxide, and tin oxide, and among these metal oxides, titanium oxide and zirconium oxide are preferable.

The first transparent coating layer 2 may further contain a material for achieving an optional function. For example, the first transparent coating layer 2 may contain an antistatic agent. Examples of the antistatic agent include surfactants, antimony pentoxide, indium-tin composite oxide (ITO), and conductive polymers.

The preferred thickness of the first transparent coating layer 2 depends on whether the third transparent coating layer 5 is included in the transparent conductive piezoelectric laminated film. When the transparent conductive piezoelectric laminated film 11 does not include the third transparent coating layer 5, the thickness of the first transparent coating layer 2 may be 600 nm or greater, and is preferably 700 nm or greater, and more preferably 800 nm or greater. Furthermore, the thickness of the first transparent coating layer 2 may be less than 1100 nm, and is preferably 1000 nm or less, and even preferably 900 nm or less.

In the transparent conductive piezoelectric laminated film that does not include the third transparent coating layer 5, the first transparent coating layer not only needs to have a predetermined refractive index in order to enhance the transparency of the transparent conductive piezoelectric laminated film, but also needs to prevent scratches and surface irregularities on the surface of the transparent piezoelectric film 1. When the thickness of the first transparent coating layer 2 is specifically not lower than the lower limit, scratches, surface irregularities, and the like on the surface of the transparent piezoelectric film 1 can be prevented, and thus, the transparency of the transparent piezoelectric film 1 increases. It is preferable that the thickness of the first transparent coating layer 2 specifically does not exceed the upper limit, to obtain a thin transparent piezoelectric film and enhance the transparency of the film.

In the transparent conductive piezoelectric laminated film 12 that includes the third transparent coating layer 5, the thickness of the first transparent coating layer 2 may be 60 nm or greater, and is preferably 70 nm or greater, and more preferably 85 nm or greater. Furthermore, the thickness of the first transparent coating layer 2 may be less than 200 nm, and is preferably 180 nm or less, and more preferably 170 nm or less. When the thickness of the first transparent coating layer is in the above-mentioned range, transparency can be imparted to the transparent conductive piezoelectric laminated film 11.

Second Transparent Coating Layer 3

The second transparent coating layer 3 in the present embodiment is a layer positioned between the first transparent coating layer 2 and the transparent electrode layer 4.

The refractive index of the second transparent coating layer 3 is from 1.30 to 1.50, for example. It is only required that the refractive index of the second transparent coating layer 3 is in this range. The refractive index of the second transparent coating layer 3 is preferably 1.35 or greater and more preferably 1.37 or greater. The refractive index of the second transparent coating layer 3 is preferably 1.48 or less and more preferably 1.47 or less.

The material of the second transparent coating layer 3 may be appropriately selected from any usable materials, as long as the material satisfies such a refractive index. For example, the material may be appropriately selected from the materials mentioned as examples of the material of the first transparent coating layer 2, to obtain an appropriate refractive index.

Similarly to the material mentioned as the material of the first transparent coating layer 2, the material of the second transparent coating layer 3 may contain another material necessary for forming a transparent coating layer. For example, in order to adjust the refractive index, the material may contain silicon dioxide or one or more metal fluorides selected from the group consisting of $NaF$, $Na_3AlF_6$, $LiF$, $MgF_2$, $CaF_2$, and $BaF_2$. Among these, silicon dioxide is preferred.

The thickness of the second transparent coating layer 3 may be 10 nm or greater, and is preferably 20 nm or greater, and more preferably 30 nm or greater. The thickness of the second transparent coating layer 3 may be 100 nm or less, and is preferably 95 nm or less, and more preferably 90 nm or less. When the thickness of the second transparent coating layer 3 is in the above-mentioned range, the transparency and the color tone of the transparent conductive piezoelectric laminated film 11 can be improved.

Third Transparent Coating Layer 5 The third transparent coating layer 5 is a layer that is optionally provided on the transparent conductive piezoelectric laminated film. When the third transparent coating layer 5 is provided, the third transparent coating layer 5 is a film layer positioned to directly contact the transparent piezoelectric film 1. For example, similarly to the transparent conductive piezoelectric laminated film 12, the third transparent coating layer 5 is a layer positioned between the transparent piezoelectric film 1 and the first transparent coating layer 2. When the first transparent coating layer 2 is provided only on one surface of the transparent piezoelectric film 1, the third transparent coating layer 5 may be provided on the other surface of the transparent piezoelectric film 1. The transparent conductive piezoelectric laminated film 11 may include the third transparent coating layers 5 on both sides of the transparent piezoelectric film 1.

The refractive index of the third transparent coating layer 5 may be 1.45 or greater, and is preferably 1.48 or greater, and more preferably 1.50 or greater. The refractive index of the third transparent coating layer 5 may be less than 1.60, and is preferably less than 1.58, and more preferably less than 1.55. When the third transparent coating layer 5 is provided on at least one surface of the transparent piezoelectric film 1, it is possible to improve the transparency of the transparent conductive piezoelectric laminated film 12.

The material of the third transparent coating layer 5 may be appropriately selected from any usable materials, as long as the material satisfies such a refractive index. For example, the material may be appropriately selected from the materials mentioned as examples of the material of the first transparent coating layer 2, to obtain an appropriate refractive index. The third transparent coating layer 5 may be a transparent surface protection layer for scratch prevention, also called a hard coat layer. It is preferable to use a material that achieves a suitable refractive index and further has excellent scratch resistance.

Furthermore, from the viewpoint of adhesiveness and prevention of films from blocking each other, inorganic particles, polymer beads, and the like may be added to the material of the third transparent coating layer 5. Examples of the inorganic particles include synthetic silica, talc, diatomaceous earth, calcium carbonate, feldspar, quartz, or the like. In particular, synthetic silica can be preferably used in order to obtain a plastic film having high quality.

The thickness of the third transparent coating layer 5 may be 500 nm or greater, and is preferably 700 nm or greater, and more preferably 900 nm or greater. When the thickness of the third transparent coating layer 5 is not less than the lower limit, an effect of protecting the transparent piezoelectric film 1 can be expected. The thickness of the third transparent coating layer 5 may be 1400 nm or less in order to obtain a thin film, and is preferably 1200 nm or less, and more preferably 1100 nm or less. When the thickness of the third transparent coating layer does not exceed the upper limit, it is possible to suppress a decrease in piezoelectric properties represented by the piezoelectric constant d31. In addition, it is possible to suppress deterioration in quality such as cracks and curling of the transparent conductive piezoelectric laminated film caused by heating in incorporation of the transparent conductive piezoelectric laminated film into a device. When the thickness of the third transparent coating layer 5 is in the above-mentioned range, it is possible to obtain the transparent conductive piezoelectric film 12 having improved transparency.

Optical Characteristics of Transparent Conductive Piezoelectric Laminated Film In the transparent conductive piezoelectric laminated film, the total transmittance is preferably high, and further, in order to achieve stable transparency, it is preferable that the color tone is suppressed. In the case of a transparent conductive piezoelectric laminated film in which the transparent electrode layer is made of an amorphous material, in particular, the transparent conductive piezoelectric laminated film is preferably a transparent conductive piezoelectric laminated film in which a yellow tone originating from the material of the transparent electrode layer is suppressed.

The yellow tone of the transparent conductive piezoelectric laminated film may be evaluated by the Yellow Index (also referred to as "YI value"). In the present embodiment, the YI value is a value determined by calculation through a method described in JIS K7373 using an XYZ-color system measured in conformity with JIS Z8722.

The Yellow Index of the transparent conductive piezoelectric laminated film is 7 or less, and is preferably 6.5 or less, and more preferably 6 or less. It is preferable that the YI value of the transparent conductive piezoelectric laminated film is equal to or less than the upper limit, because in this case, the yellow tone is suppressed. The YI value may be -7 or greater, and is preferably -5 or greater, and more preferably -3 or greater. It is preferable that the YI value of the transparent conductive piezoelectric laminated film is equal to or greater than the lower limit, because in this case, blueness of the transparent conductive piezoelectric laminated film is suppressed. Note that the YI value is preferably as close to 0 as possible.

A color tone other than the yellow tone may be evaluated by the a* value in the L*a*b* color system measured in conformity with JIS Z8722. The a* value of the transparent conductive piezoelectric film may be -1.5 or greater, and is preferably -1.2 or greater, and more preferably -1.0 or greater. When the a* value is not lower than the lower limit, it can be assured that a green tone is suppressed. The a* value may be 1.0 or less, and is preferably 0.8 or less, and more preferably 0.7 or less. When the a* value of the transparent conductive piezoelectric laminated film is in this range, it can be assured that a red tone is suppressed. It is preferable that the a* value is as close to 0 as possible because in this case, it can be assured that the color tone is suppressed. The a* value can be measured by a known method described in JIS Z8722 by using a spectrophotometer, for example.

Device

A device according to one embodiment of the present invention includes the transparent conductive piezoelectric laminated film according to the embodiment described above. The device may be any device, as long as the device includes the transparent conductive piezoelectric laminated film according to the present embodiment. For example, a position and number of the transparent conductive piezoelectric laminated film can be appropriately determined in accordance with the application or a desired function of the device.

The transparent conductive piezoelectric laminated film according to one embodiment has suitable conductivity and a high piezoelectric constant, as described above. Each layer of the transparent conductive piezoelectric laminated film can be formed by making the material of each layer in a form of ink and coating or printing the material in the form of ink. Furthermore, the transparent conductive piezoelectric laminated film according to one embodiment has chemical stability and film flexibility. By utilizing these characteristics, the application of the transparent conductive piezoelectric laminated film according to one embodiment to a device such as a sensor having flexibility including a pressure sensor and a vibration sensor, an energy harvesting element, and an actuator is being studied. When the transparent conductive piezoelectric laminated film according to one embodiment is applied to a device, the transparent conductive piezoelectric laminated films may be bonded to each other to form a transparent conductive piezoelectric body having a bimorph structure, and the transparent conductive piezoelectric body may be applied to the device. The transparent conductive piezoelectric body having a bimorph structure is preferable in that the displacement relative to an applied voltage is increased.

When the transparent conductive piezoelectric laminated film according to one embodiment is applied to a device, in the production of the device, a transparent adhesive sheet may be formed not only on any one of the transparent coating layers, but also on another layer that adheres to the transparent coating layer via a transparent adhesive sheet. In this case, a transparent adhesive sheet layer may or may not be present on the transparent coating layer side.

In a device incorporating the transparent conductive piezoelectric laminated film according to one embodiment, the transparent conductive piezoelectric film also functions as an electrode. Therefore, it is possible to eliminate the electrode layer that is included in known devices and made of PET/ITO, for example. Thus, a layer structure of the device can be simplified compared to a known device.

Method of Producing Transparent Piezoelectric Laminated Film

A method of producing a transparent conductive piezoelectric laminated film will be described below using the transparent conductive piezoelectric laminated film 11 as an example. The method of producing the transparent conductive piezoelectric laminated film 11 is a method of producing a laminated film in which the first transparent coating layer 2, the second transparent coating layer 3, and the transparent electrode layer 4 are stacked in this order on at least one surface of the transparent piezoelectric film 1. The production method includes a first step of producing the transparent piezoelectric film 1 forming a film having a refractive index of 1.30 or greater and less than 1.45, a second step of forming the first transparent coating layer 2 having a refractive index of 1.60 or greater and less than 1.80 on at least one surface of the transparent piezoelectric film 1, a third step of forming the second transparent coating layer 3 having a refractive index of 1.30 or greater and less than 1.50 on the surface of the first transparent coating layer 2, and a fourth step of forming the transparent electrode layer 4 having a refractive index of 1.80 to 2.20 on the surface of the second transparent coating layer 3.

The first step is only required to be a step of preparing the transparent piezoelectric film 1, and the step may be appropriately changed or a step may be added in accordance with the type of the transparent piezoelectric film 1 to be prepared. For example, the transparent piezoelectric film 1 can be prepared by continuously performing a step of preparing a resin film by a known method such as a casting method, a hot pressing method, or a melt extrusion method, a step of stretching the resin film, and a step of subjecting the non-polarized resin film to a polarization treatment.

The second step to the fourth step can be suitably implemented by utilizing a known coating method such as a wet coating method or a dry coating method. In general, in the wet coating method, a layer is formed by applying a material, and thus, the wet coating method is suitable for forming a layer having a large film thickness. In the dry coating method, a layer is formed by finely depositing a material, and thus, the dry coating method is suitable for forming a layer having a small film thickness. By applying a known technique in accordance with these advantages, each step from the second step to the fourth step can be suitably implemented.

The second step is a step of forming a first transparent coating layer. The second step is preferably implemented by a wet coating method, from the viewpoint of productivity and manufacturing cost. In the second step using the wet coating method, the material of the first transparent coating layer only needs to be applied to at least one surface of the transparent piezoelectric film 1 prepared in the first step. The coating method may be a known method and is not particularly limited. The wet coating method can be a known method, and typical examples thereof include a roll coating method, a spin coating method, a dip coating method, and a gravure coating method. Among these methods, a method capable of continuously forming layers, such as the roll coating method and the gravure coating method, is more preferable from the viewpoint of productivity.

For example, a bar coater, a gravure coater, or the like may be used to apply the material of the first transparent coating layer 2. After the material is applied, the material may be dried under conditions of 50°C to 180°C for 0.5 to 60 minutes. Furthermore, a dried coating film of the first transparent coating layer 2 may be solidified by UV irradiation. For example, a UV irradiation apparatus may be used to irradiate the first transparent coating layer 2 with UV light having a cumulative light amount of 50 to 1200 mJ/cm$^2$, to solidify the first transparent coating layer 2. An apparatus, a concentration of the material, and conditions such as a temperature used in the second step may be appropriately changed with reference to the material, the film thickness, and the like of the first transparent coating layer 2.

The third step is a step of forming a second transparent coating layer. In the third step, a coating film of the material of the second transparent coating layer 3 is only required to be applied by a known method to the first transparent coating layer 2 prepared in the second step. For example, in the third step, similarly to the first transparent coating layer 2, the material of the second transparent coating layer 3 may be applied by using a wet coating method. When the third step is implemented by using a wet coating method, an apparatus, a concentration of the material, and conditions such as a temperature in the third step may be similar to those in the second step. The film thickness of the second transparent coating layer 3 can be adjusted by adjusting the concentration of the material, for example.

Depending on the material of the second transparent coating layer 3, it is also suitable to form the coating film by a dry coating method such as a sputtering method. When the third step is implemented by a dry coating method, the film thickness of the second transparent coating layer 3 can be adjusted by adjusting the sputtering time, for example.

In the third step using the dry coating method, the material of the second transparent coating layer 3 may be deposited by a known dry coating method on the first transparent coating layer 2 prepared in the second step. Typical examples of the dry coating method include a sputtering method, a vacuum deposition method, and an ion plating method. These methods may be appropriately selected in accordance with the required film thickness.

For example, when the sputtering method is employed in the third step, examples of the target material include the inorganic materials constituting the second transparent coating layer, and an example thereof includes Si. Examples of a sputtering gas include an inert gas such as Ar. In addition, a reactive gas, such as oxygen gas, can be used in combination as necessary.

The fourth step is a step of forming a transparent electrode layer. In the fourth step, it is only required that the transparent electrode layer 4 is formed by a known method on the second transparent coating layer 3 prepared in the third step. When forming the transparent electrode layer 4, it is only required that the material of the transparent electrode layer 4 is deposited by a method such as a sputtering method, a vacuum deposition method, or an ion plating method. For example, when forming the transparent electrode layer 4, similarly to the second transparent coating layer 3, the material of the transparent electrode layer may be applied by using a wet coating method.

The fourth step will be described in more detail below by using, as an example, a configuration in which the transparent electrode layer is formed by employing a sputtering method in the fourth step. When the sputtering method is employed, examples of the target material include the above-mentioned inorganic materials constituting the transparent electrode layer 4, and preferably include ITO. The concentration of tin oxide in ITO is, for example, 0.5 mass% or greater, and preferably 2 mass% or greater, and further, for example, 15 mass% or less, preferably 13 mass% or less, and more preferably 7 mass% or less.

Examples of a sputtering gas include an inert gas such as Ar. In addition, a reactive gas such as oxygen gas, can be used in combination as necessary. When a reactive gas is used in combination, the flow rate ratio of the reactive gas is not particularly limited and is, for example, from 0.1 flow rate% to 5 flow rate% with respect to a total flow rate of the sputtering gas and the reactive gas.

The atmospheric pressure during sputtering is, for example, 1 Pa or less and preferably 0.7 Pa or less, in order to suppress a reduction in the sputtering rate and obtain stable discharge, and the like.

The power supply used in the sputtering method may be, for example, any of a DC power supply, an AC power supply, an MF power supply, and an RF power supply, or alternatively may be a combination of these.

The production method of the present embodiment may further include another step, as long as the production method includes the first step to the fourth step. For example, the third transparent coating layer 5 may be formed on the transparent piezoelectric film 1 between the first step and the second step. The third transparent coating layer 5 may be formed by applying, through a known method, the material of the third transparent coating layer 5 onto the transparent piezoelectric film 1 prepared in the first step.

A step of adding another layer configuration to the transparent conductive piezoelectric laminated film 11 may be added. Furthermore, a step of treating the transparent piezoelectric film 1 by a corona treatment to increase adhesion to the first transparent coating layer 2 may be added.

According to the production method of the present embodiment, it is possible to produce the transparent conductive piezoelectric laminated film 11 having high transparency and a suitable color tone.

In the production method of the present embodiment, it is not necessary to implement an annealing treatment of the transparent electrode layer 4 after the fourth step. If the annealing treatment is not performed, the color tone of the transparent piezoelectric film 1 is not impaired. Therefore, it is possible to prepare the transparent conductive piezoelectric laminated film 11 that can be suitably used for a device such as a display.

The present invention is not limited to the embodiments described above, and may be variously modified within the scope as defined by the claims. Embodiments obtained by appropriately combining technical means disclosed in different embodiments are also included in the technical scope of the present invention.

Examples

Examples of the present invention will be described below.

Method of Producing Transparent Conductive Piezoelectric Laminated Film

Example 1

First Step: Preparation of Transparent Piezoelectric Film

A resin film (thickness 120 $\mu$m) formed from polyvinylidene fluoride (available from Kureha Corporation) having an inherent viscosity of 1.3 dl/g was stretched in a stretching ratio of 4.2 times. After the film was stretched, the film was passed through a polarization roll for a polarization treatment, to obtain a piezoelectric film. Here, the polarization treatment was performed by applying a DC voltage while the DC voltage was increased from 0 kV to 11.0 kV. After the polarization treatment, the film was further heated at 130°C for 1 minute, to obtain a transparent piezoelectric film having a refractive index of 1.42 and a thickness of 40 $\mu$m.

Second Step: Formation of First Transparent Coating Layer

An amorphous silica-containing ultraviolet-curable resin composition including an acrylic resin was applied onto an upper surface (surface A) of the transparent piezoelectric film. The obtained product was dried at 80°C, and then irradiated with ultraviolet rays having a cumulative light amount of 400 mJ/cm$^2$, to form a third transparent coating layer (thickness 1000 nm, refractive index 1.52). Next, the third transparent coating layer (thickness 1000 nm, refractive index 1.52) was also formed on a lower surface (surface B) of the transparent piezoelectric film by a similar method. Subsequently, an ultraviolet-curable resin composition containing zirconium oxide particles was applied onto an upper surface of the third transparent coating layer (surface A). The obtained product was dried at 80°C, and then, irradiated with ultraviolet rays having a cumulative light amount of 400 mJ/cm$^2$ to form a first transparent coating layer (thickness 100 nm, refractive index 1.65).

Third Step: Formation of Second Transparent Coating Layer

A hollow silica-containing ultraviolet-curable resin composition including an acrylic resin was applied onto the first transparent coating layer. The obtained product was dried at 80°C, and then irradiated with ultraviolet rays having a cumulative light amount of 400 mJ/cm$^2$, to form a second transparent coating layer (thickness 44 nm, refractive index 1.37).

Fourth Step: Formation of Transparent Electrode Layer

Next, an ITO film having a refractive index of 1.88 and a thickness of 19 nm as a transparent electrode layer was formed on the second transparent coating layer by a reactive sputtering method using, as a target, a sintered compact material containing 97 mass% of indium oxide and 3 mass% of tin oxide. Thus, a transparent conductive piezoelectric laminated film was obtained, and the obtained transparent conductive piezoelectric laminated film was used as Example 1.

Example 2

A transparent conductive piezoelectric laminated film was obtained similarly to Example 1. except that the thickness of the transparent electrode layer was 12 nm. The obtained transparent conductive piezoelectric laminated film was used as Example 2.

Example 3

A transparent conductive piezoelectric laminated film was obtained similarly to Example 1. except that the thickness of the transparent electrode layer was 8 nm. The obtained transparent conductive piezoelectric laminated film was used as Example 3.

Example 4

A transparent conductive piezoelectric laminated film was obtained similarly to Example 2, except that the thickness of the second coating layer was 81 nm. The obtained transparent conductive piezoelectric laminated film was used as Example 4

Example 5

The third transparent coating layer was not formed on the surface A and the surface B of the transparent piezoelectric film, and the first transparent coating layer, the second transparent coating layer, and the transparent electrode layer were formed in this order on the surface A of the transparent piezoelectric film. A transparent conductive piezoelectric laminated film was obtained similarly to Example 2, except that the thickness of the first transparent coating layer was 850 nm, the refractive index was 1.70, and the thickness of the second transparent coating layer was 67 nm. The obtained transparent conductive piezoelectric laminated film was used as Example 5.

Example 6

A transparent conductive piezoelectric laminated film was obtained similarly to Example 2, except that the thickness of the first transparent coating layer was 120 nm, the refractive index was 1.70, and the thickness of the second coating layer was 50 nm. The obtained transparent conductive piezoelectric laminated film was used as Example 6.

Example 7

A transparent conductive piezoelectric laminated film was obtained similarly to Example 2, except that the thickness of the first transparent coating layer was 90 nm, the refractive index was 1.75, and the thickness of the second coating layer was 49 nm. The obtained transparent conductive piezoelectric laminated film was used as Example 7.

Example 8

A transparent conductive piezoelectric laminated film was obtained similarly to Example 6, except that the thickness of the first transparent coating layer was 163 nm and the thickness of the second transparent coating layer was 88 nm. The obtained transparent conductive piezoelectric laminated film was used as Example 8.

Example 9

Formation of First Transparent Coating Layer

A third transparent coating layer was formed on both surfaces of the transparent piezoelectric film by a similar method as in Example 1, and a first transparent coating layer (thickness 100 nm, refractive index 1.65) was further formed on the surface A.

Formation of Second Transparent Coating Layer

Next, a $SiO_2$ film was formed on the first transparent coating layer by an AC magnetron sputtering method using Si as a target material. Specifically, a chamber was evacuated to $7 \times 10^{-4}$ Pa or less. Afterwards, a mixed gas of Ar gas and oxygen gas was introduced into the chamber and a $SiO_2$ film having a thickness of 25 nm was deposited to form a second transparent coating layer (thickness 25 nm, refractive index 1.46).

Formation of Transparent Electrode Layer

A transparent electrode layer was formed on the second transparent coating layer similarly to Example 1, except that the thickness of the ITO film was 19 nm. Thus, a transparent conductive piezoelectric laminated film was obtained, and the obtained transparent conductive piezoelectric laminated film was used as Example 9.

Example 10

A transparent conductive piezoelectric laminated film was obtained similarly to Example 9, except that the thickness of the first transparent coating layer was 105 nm and the refractive index was 1.70. The obtained transparent conductive piezoelectric laminated film was used as Example 10.

Example 11

A transparent conductive piezoelectric laminated film in which the $d_{31}$ is improved was obtained similarly to Example 10, except that the DC voltage in the first step was changed to 11.5 kV. The obtained transparent conductive piezoelectric laminated film was used as Example 11.

Example 12

A transparent conductive piezoelectric laminated film was obtained similarly to Example 1, except that the thickness of the first transparent coating layer was 99 nm, the thickness of the second transparent coating layer was 81 nm, and the thickness of the transparent electrode layer was 5 nm. The obtained transparent conductive piezoelectric laminated film was used as Example 11.

Comparative Example 1

A conductive piezoelectric laminated film was obtained similarly to Example 1, except that the third transparent coating layer, the first transparent coating layer, and the second transparent coating layer were not formed. The obtained conductive piezoelectric laminated film was used as Comparative Example 1.

Comparative Example 2

A conductive piezoelectric laminated film was obtained similarly to Example 1, except that the thickness of the second transparent coating layer was 81 nm and the thickness of the transparent electrode layer was 27 nm. The obtained conductive piezoelectric laminated film was used as Comparative Example 2.

Comparative Example 3

A conductive piezoelectric laminated film was obtained similarly to Example 2, except that the second transparent coating was not formed. The obtained conductive piezoelectric laminated film was used as Comparative Example 3.

Comparative Example 4

A conductive piezoelectric laminated film was obtained similarly to Example 1, except that the refractive index of the first transparent coating layer was 1.52, the refractive index of the second transparent coating layer was 1.40, and the thickness of the second transparent coating layer was 80 nm. The obtained conductive piezoelectric laminated film was used as Comparative Example 4.

Comparative Example 5

A conductive piezoelectric laminated film was obtained similarly to Comparative Example 4, except that the second transparent coating layer was not formed. The obtained conductive piezoelectric laminated film was used as Comparative Example 5.

Comparative Example 6

A conductive piezoelectric laminated film was obtained similarly to Example 10, except that the thickness of the second transparent coating layer was 28 nm, the refractive index was 1.52, and the thickness of the transparent electrode layer was 12 nm. The obtained conductive piezoelectric laminated film was used as Comparative Example 6.

Comparative Example 7

A conductive piezoelectric laminated film was obtained similarly to Comparative Example 6, except that the thickness of the second transparent coating layer was 111 nm and the refractive index was 1.40. The obtained conductive piezoelectric laminated film was used as Comparative Example 7.

Comparative Example 8

A conductive piezoelectric laminated film was obtained similarly to Example 9, except that the thickness of the first transparent coating layer was 40 $\mu$m, the refractive index was 1.55, the thickness of the second transparent coating layer was 40 $\mu$m, and sputtering was performed using indium oxide containing 36 mass% of tin oxide as a target. The obtained conductive piezoelectric laminated film was used as Comparative Example 8.

Comparative Example 9

A conductive piezoelectric laminated film was obtained similarly to Example 10, except that the thickness of the first coating layer was changed to 201 nm. The obtained conductive piezoelectric laminated film was used as Comparative Example 9.

Thickness Measurement of Each Layer

The thicknesses of the layers constituting the transparent conductive piezoelectric laminated films of Examples 1 to 12 and Comparative Examples 1 to 9 were measured as described below.

Thicknesses of Transparent Coating Layers The thicknesses of the transparent coating layers and the transparent electrode layer constituting the transparent conductive piezoelectric laminated films and the conductive piezoelectric laminated films (hereinafter, also simply referred to as "conductive piezoelectric laminated films") of Examples 1 to 12 and Comparative Examples 1 to 9 were determined by the method described below in which the thickness is observed by using an electron microscope. In the method, first, the transparent conductive piezoelectric laminated film was embedded in an epoxy resin, and the epoxy resin mass was cut to expose a cross section of the transparent conductive piezoelectric laminated film. The exposed cross-section of the transparent conductive piezoelectric laminated film was observed using a scanning electron microscope ("SU3800", available from Hitachi High-Tech Corporation) under the conditions of an acceleration voltage of 3.0 kV and a magnification of 50000 times. The thickness of the transparent conductive piezoelectric laminated film and the individual films or layers in the transparent conductive piezoelectric laminated film is measured.

The refractive index of each layer in the conductive piezoelectric laminated films of Examples 1 to 12 and Comparative Examples 1 to 9 is listed in Table 1.

[Table 1]

Table 1

| | | Refractive index | | | |
| | | Transparent piezoelectric film | Third transparent coating layer | First transparent coating layer | Second transparent coating layer | Transparent electrode layer |
|---|---|---|---|---|---|---|
| | Example 1 | 1.42 | 1.52 | 1.65 | 1.37 | 1.88 |
| | Example 2 | 1.42 | 1.52 | 1.65 | 1.37 | 1.88 |
| | Example 3 | 1.42 | 1.52 | 1.65 | 1.37 | 1.88 |
| | Example 4 | 1.42 | 1.52 | 1.65 | 1.37 | 1.88 |
| | Example 5 | 1.42 | - | 1.70 | 1.37 | 1.88 |
| | Example 6 | 1.42 | 1.52 | 1.70 | 1.37 | 1.88 |
| | Example 7 | 1.42 | 1.52 | 1.75 | 1.37 | 1.88 |
| | Example 8 | 1.42 | 1.52 | 1.70 | 1.37 | 1.88 |
| | Example 9 | 1.42 | 1.52 | 1.65 | 1.46 | 1.88 |
| | Example 10 | 1.42 | 1.52 | 1.70 | 1.46 | 1.88 |
| | Example 11 | 1.42 | 1.52 | 1.70 | 1.46 | 1.88 |
| | Example 12 | 1.42 | 1.52 | 1.65 | 1.37 | 1.88 |
| Comparative Example 1 | | 1.42 | - | - | - | 1.88 |
| Comparative Example 2 | | 1.42 | 1.52 | 1.65 | 1.37 | 1.88 |
| Comparative Example 3 | | 1.42 | 1.52 | 1.65 | - | 1.88 |
| Comparative Example 4 | | 1.42 | 1.52 | 1.52 | 1.40 | 1.88 |
| Comparative Example 5 | | 1.42 | 1.52 | - | 1.40 | 1.88 |
| Comparative Example 6 | | 1.42 | 1.52 | 1.70 | 1.52 | 1.88 |
| Comparative Example 7 | | 1.42 | 1.52 | 1.70 | 1.40 | 1.88 |
| Comparative Example 8 | | 1.42 | - | 1.55 | 1.46 | 1.95 |
| Comparative Example 9 | | 1.42 | 1.52 | 1.70 | 1.46 | 1.88 |

The thicknesses of the layers in the conductive piezoelectric laminated films of
Examples 1 to 12 and Comparative Examples 1 to 9 are listed in Table 2.

[Table 2]

Table 2

| | | Thickness | | | | |
|---|---|---|---|---|---|---|
| | | Transparent piezoelectric film (μm) | Third transparent coating layer (μm) | First transparent coating layer (nm) | Second transparent coating layer (nm) | Transparent electrode layer (nm) |
| | Example 1 | 40 | 1.0 | 100 | 44 | 19 |
| | Example 2 | 40 | 1.0 | 100 | 44 | 12 |
| | Example 3 | 40 | 1.0 | 100 | 44 | 8 |
| | Example 4 | 40 | 1.0 | 100 | 81 | 12 |
| | Example 5 | 40 | - | 850 | 67 | 12 |
| | Example 6 | 40 | 1.0 | 120 | 50 | 12 |
| | Example 7 | 40 | 1.0 | 90 | 49 | 12 |
| | Example 8 | 40 | 1.0 | 163 | 88 | 12 |
| | Example 9 | 40 | 1.0 | 100 | 25 | 19 |
| | Example 10 | 40 | 1.0 | 105 | 25 | 19 |
| | Example 11 | 40 | 1.0 | 105 | 25 | 19 |
| | Example 12 | 40 | 1.0 | 99 | 81 | 5 |
| | Comparative Example 1 | 40 | - | - | - | 19 |
| | Comparative Example 2 | 40 | 1.0 | 100 | 81 | 27 |
| | Comparative Example 3 | 40 | 1.0 | 100 | - | 12 |
| | Comparative Example 4 | 40 | 1.0 | 100 | 80 | 19 |
| | Comparative Example 5 | 40 | 1.0 | - | 80 | 19 |
| | Comparative Example 6 | 40 | 1.0 | 105 | 28 | 12 |
| | Comparative Example 7 | 40 | 1.0 | 105 | 111 | 12 |
| | Comparative Example 8 | 40 | - | 40 | 40 | 15 |
| | Comparative Example 9 | 40 | 1.0 | 201 | 25 | 19 |

Evaluation

In the conductive piezoelectric laminated films of Examples 1 to 12 and Comparative

Examples 1 to 9, physical properties and optical characteristics of the laminated films were evaluated.

Evaluation of Physical Properties

Surface Resistance Value

The surface resistance value (Ω/sq) of each of the conductive piezoelectric laminated films of Examples 1 to 12 and Comparative Examples 1 to 9 was measured in conformity with JIS K7194 using a resistivity meter ("Loresta-GP MCP-T610", available from Nittoseiko Analytech Co., Ltd.). The measurement was performed three times, and the average value of the three results was determined as a representative value. When the surface resistance value is 300 Ω/sq or greater and less than 1700 Ω/sq, it can be assured that the film can be used without practical problems in a device.

Value of Piezoelectric Constant $d_{31}$

The piezoelectric constant $d_{31}$ of each of the conductive piezoelectric laminated films of

Examples 1 to 12 and Comparative Examples 1 to 9 was calculated by the following formula, by measuring a charge corresponding to the tensile stress using a force gauge, an electric stand, and an electrometer.

$$d_{31} = (Q/A)(t \cdot w/F)$$

In the equation above, Q is the charge, A is an electrode area, t is the thickness of the conductive piezoelectric laminated film, w is a width of the conductive piezoelectric laminated film, and F is a force applied to the conductive piezoelectric laminated film

A test piece used in the measurement was obtained by forming aluminum electrodes on a front surface and a back surface of the conductive piezoelectric laminated film by a vapor deposition method. When the value of the piezoelectric constant $d_{31}$ is from 10 pC/N to 40 pC/N, it can be assured that the film can be used without practical problems in a device.

Evaluation of Optical Characteristics

Total Transmittance

The total transmittance of each of the conductive piezoelectric laminated films of Examples 1 to 12 and Comparative Examples 1 to 9 was measured using a haze meter ("NDH 7000SPII", available from Nippon Denshoku Industries Co., Ltd.), based on a method described in JIS K7361-1. When the total transmittance is 90% or greater, the laminated film can be used in a device without practical problems and it is preferable when the total transmittance is higher.

Yellow Index

The Yellow Index (YI value) was calculated by a method described in JIS K7373 using an XYZ-color system measured by a method in conformity with JIS Z8722, by using a spectrophotometer ("SD 7000", available from Nippon Denshoku Industries Co., Ltd.).

a* value

The a* value in the L*a*b* color system was measured by a method in conformity with JIS Z8722 using a spectrophotometer ("SD 7000", available from Nippon Denshoku Industries Co., Ltd.). When the a* value is from -1.0 to 1.0, it can be assured that the film can be preferably used in an application of a device.
The results of the above-described evaluations are listed in Table 3.

[Table 3]

Table 3

| | Physical properties | | Optical characteristics | | |
|---|---|---|---|---|---|
| | Surface resistance value ($\Omega$/sq) | d31 (pC/N) | Total transmittance (%) | YI (-) | a* (-) |
| Example 1 | 323 | 15.9 | 92.8 | 5.9 | -0.6 |
| Example 2 | 515 | 15.9 | 94.3 | 2.4 | -0.5 |
| Example 3 | 833 | 15.9 | 94.2 | 0.1 | -0.4 |
| Example 4 | 572 | 15.9 | 94.3 | 5.6 | -0.6 |
| Example 5 | 560 | 15.9 | 94.2 | 2.7 | -0.2 |
| Example 6 | 637 | 15.9 | 94.1 | 3.4 | -0.6 |
| Example 7 | 602 | 15.9 | 93.3 | -0.2 | -0.7 |
| Example 8 | 429 | 13.9 | 91.7 | 5.2 | -0.7 |
| Example 9 | 400 | 15.9 | 91.0 | 4.0 | -1.1 |
| Example 10 | 410 | 13.9 | 91.0 | 2.7 | -1.3 |
| Example 11 | 393 | 24.5 | 90.5 | 5.5 | -0.3 |
| Example 12 | 1610 | 15.9 | 93.3 | -3.2 | -0.3 |
| Comparative Example 1 | 270 | 15.9 | 88.1 | 7.1 | 0.0 |
| Comparative Example 2 | 194 | 15.9 | 79.6 | 18.5 | 2.3 |
| Comparative Example 3 | 497 | 15.9 | 87.8 | 0.6 | -0.4 |
| Comparative Example 4 | 230 | 15.9 | 86.6 | 7.4 | 0.0 |
| Comparative Example 5 | 224 | 15.9 | 86.6 | 9.4 | 0.0 |
| Comparative Example 6 | 443 | 13.9 | 87.5 | 0.1 | -0.3 |

(continued)

| | Physical properties | | Optical characteristics | | |
|---|---|---|---|---|---|
| | Surface resistance value (Ω/sq) | d31 (pC/N) | Total transmittance (%) | YI (-) | a* (-) |
| Comparative Example 7 | 414 | 13.9 | 86.9 | 6.5 | 1.5 |
| Comparative Example 8 | 460 | 13.9 | 88.5 | 7.0 | -0.9 |
| Comparative Example 9 | 392 | 13.9 | 87.7 | 2.0 | 1.3 |

As listed in Table 3, the conductive piezoelectric laminated films of Examples 1 to 12 each had physical properties such that the film can be used without practical problems in a device, and further has high transparency. On the other hand, the total transmittance of each of the conductive piezoelectric laminated films of Comparative Examples 1 to 9 was 90% or less.

Industrial Applicability

The present invention can be utilized in a device requiring piezoelectric properties.

Reference Signs List

1 Transparent piezoelectric laminated film
2 First transparent coating layer
3 Second transparent coating layer
4 Transparent electrode layer
5 Third transparent coating layer
11, 12 Transparent conductive piezoelectric laminated film

**Claims**

1. A transparent conductive piezoelectric laminated film (11,12) comprising a transparent

   electrode layer (4) provided on a piezoelectric film (1), wherein the piezoelectric film is a film made of a resin, **characterised in that** the transparent conductive piezoelectric laminated film has a piezoelectric constant $d_{31}$ of from 10 pC/N to 40 pC/N and a total transmittance of 90% or greater, and
   a Yellow Index calculated by a method described in JIS K7373 using an XYZ-color system measured in conformity with JIS Z8722 is 7 or less.

2. The transparent conductive piezoelectric laminated film according to claim 1, wherein

   at least one surface of the transparent conductive piezoelectric laminated film is formed of the transparent electrode layer, and
   the surface has a surface resistance value of 300 Ω/sq or greater and less than 1700 Ω/sq.

3. The transparent conductive piezoelectric laminated film according to claim 2, wherein the surface resistance value is less than 1000 Ω/sq.

4. The transparent conductive piezoelectric laminated film according to claim 1, wherein a* in an L*a*b* color system measured in conformity with JIS Z8722 is from -1.5 to 1.0.

5. The transparent conductive piezoelectric laminated film (12) according to claim 1, wherein

   the transparent conductive piezoelectric laminated film comprises a third transparent coating layer (5), a first transparent coating layer (2), a second transparent coating layer (3) and the transparent electrode layer (4) stacked in this order on at least one surface of a transparent piezoelectric film (1),

the transparent piezoelectric film (1) has a refractive index of 1.30 or greater and less than 1.45,
the third transparent coating layer (5) has a refractive index of 1.45 or greater and less than 1.60,
the first transparent coating layer (2) has a refractive index of 1.60 or greater and less than 1.80,
the second transparent coating layer (3) has a refractive index of 1.30 to 1.50,
the transparent electrode layer (4) has a refractive index of 1.80 to 2.20,
the first transparent coating layer has a thickness of 60 nm or greater and less than 200 nm,
the second transparent coating layer has a thickness of 10 nm to 100 nm, and
the third transparent coating layer has a thickness of 500 nm to 1400 nm.

6. The transparent conductive piezoelectric laminated film (11) according to claim 1, wherein

the transparent conductive piezoelectric laminated film comprises a first transparent coating layer (2), a second transparent coating layer (3), electrode layer (4) stacked in this order on at least one surface of a transparent piezoelectric film (1),
the transparent piezoelectric film (1) has a refractive index of 1.30 or greater and less than 1.45,
the first transparent coating layer (2) has a refractive index of 1.60 or greater and less than 1.80,
the second transparent coating layer (3) has a refractive index of 1.30 to 1.50,
the transparent electrode layer (4) has a refractive index of 1.80 to 2.20,
the first transparent coating layer has a thickness of 600 nm or greater and less than 1100 nm, and
the second transparent coating layer has a thickness of 10 nm to 100 nm.

7. The transparent conductive piezoelectric laminated film according to claim 5 or 6, wherein the transparent electrode layer has a thickness of 7 nm or greater and less than 20 nm

8. The transparent conductive piezoelectric laminated film according to claim 5 or 6, wherein the transparent piezoelectric film comprises a fluororesin as a main component.

9. The transparent conductive piezoelectric laminated film according to claim 5 or 6, wherein the transparent electrode layer has a refractive index of 1.94 or less.

10. The transparent conductive piezoelectric laminated film according to claim 5, wherein

the transparent conductive piezoelectric laminated film comprises the third transparent coating layer, the first transparent coating layer, the second transparent coating layer, and the transparent electrode layer stacked in this order on one surface of the transparent piezoelectric film, and
the transparent conductive piezoelectric laminated film comprises another one of the third transparent coating layer on the other surface of the transparent piezoelectric film.

11. The transparent conductive piezoelectric laminated film according to claim 6, wherein

the transparent conductive piezoelectric laminated film comprises the first transparent coating layer, the second transparent coating layer, and the transparent electrode layer stacked in this order on one surface of the transparent piezoelectric film,
the transparent conductive piezoelectric laminated film comprises a third transparent coating layer on the other surface of the transparent piezoelectric film,
the third transparent coating layer has a refractive index of 1.45 or greater and less than 1.60, and
the third transparent coating layer has a thickness of 500 nm to 1400 nm.

12. A device comprising the transparent conductive piezoelectric laminated film described in claim 1.

13. A method of producing a transparent conductive piezoelectric laminated film (11,12), being a method of producing a laminated film in which a first transparent coating

layer (2), a second transparent coating layer (3), and a transparent electrode layer (4) are stacked in this order on at least one surface of a transparent piezoelectric film (1),
the method comprising:

producing the transparent piezoelectric film forming a film having a refractive index of 1.30 or greater and less than 1.45,
forming the first transparent coating layer having a refractive index of 1.60 or greater and less than 1.80 on at least one surface of the transparent piezoelectric film, forming the second transparent coating layer having a refractive index of 1.30 or greater and less than 1.50 on a surface of the first transparent coating layer, and forming the transparent electrode layer having a refractive index of 1.80 to 2.20 on a surface of the second transparent coating layer.

**Patentansprüche**

1. Transparente leitfähige piezoelektrische Verbundfolie (11, 12), umfassend eine transparente Elektrodenschicht (4), die auf einer piezoelektrischen Folie (1) bereitgestellt ist, wobei

   die piezoelektrische Folie eine Folie ist, die aus einem Harz hergestellt ist, **dadurch gekennzeichnet, dass** die transparente leitfähige piezoelektrische Verbundfolie eine piezoelektrische Konstante $d_{31}$ von 10 pC/N bis 40 pC/N und eine Gesamtdurchlässigkeit von 90 % oder mehr aufweist, und ein Gelbindex, der durch ein Verfahren, das in JIS K7373 beschrieben wird, unter Verwendung eines XYZ-Farbsystems berechnet wird, das in Übereinstimmung mit JIS Z8722 gemessen wird, 7 oder weniger beträgt.

2. Transparente leitfähige piezoelektrische Verbundfolie nach Anspruch 1, wobei

   mindestens eine Oberfläche der transparenten leitfähigen piezoelektrischen Verbundfolie aus der transparenten Elektrodenschicht ausgebildet ist, und die Oberfläche einen Oberflächenwiderstandswert von 300 $\Omega$/sq oder mehr und weniger als 1700 $\Omega$/sq aufweist.

3. Transparente leitfähige piezoelektrische Verbundfolie nach Anspruch 2, wobei der Oberflächenwiderstandswert weniger als 1000 $\Omega$/sq beträgt.

4. Transparente leitfähige piezoelektrische Verbundfolie nach Anspruch 1, wobei a* in einem L*a*b*-Farbsystem, das in Übereinstimmung mit JIS Z8722 gemessen wird, von -1,5 bis 1,0 beträgt.

5. Transparente leitfähige piezoelektrische Verbundfolie (12) nach Anspruch 1, wobei

   die transparente leitfähige piezoelektrische Verbundfolie eine dritte transparente Beschichtungsschicht (5), eine erste transparente Beschichtungsschicht (2), eine zweite transparente Beschichtungsschicht (3) und die transparente Elektrodenschicht (4) umfasst, die in dieser Reihenfolge auf mindestens einer Oberfläche einer transparenten piezoelektrischen Folie (1) gestapelt sind, die transparente piezoelektrische Folie (1) einen Brechungsindex von 1,30 oder mehr und weniger als 1,45 aufweist, die dritte transparente Beschichtungsschicht (5) einen Brechungsindex von 1,45 oder mehr und weniger als 1,60 aufweist, die erste transparente Beschichtungsschicht (2) einen Brechungsindex von 1,60 oder mehr und weniger als 1,80 aufweist, die zweite transparente Beschichtungsschicht (3) einen Brechungsindex von 1,30 bis 1,50 aufweist, die transparente Elektrodenschicht (4) einen Brechungsindex von 1,80 bis 2,20 aufweist, die erste transparente Beschichtungsschicht eine Dicke von 60 nm oder mehr und weniger als 200 nm aufweist, die zweite transparente Beschichtungsschicht eine Dicke von 10 nm bis 100 nm aufweist, und die dritte transparente Beschichtungsschicht eine Dicke von 500 nm bis 1400 nm aufweist.

6. Transparente leitfähige piezoelektrische Verbundfolie (11) nach Anspruch 1, wobei

   die transparente leitfähige piezoelektrische Verbundfolie eine erste transparente Beschichtungsschicht (2), eine zweite transparente Beschichtungsschicht (3) und die transparente Elektrodenschicht (4) umfasst, die in dieser Reihenfolge auf mindestens einer Oberfläche einer transparenten piezoelektrischen Folie (1) gestapelt sind,

die transparente piezoelektrische Folie (1) einen Brechungsindex von 1,30 oder mehr und weniger als 1,45 aufweist,

die erste transparente Beschichtungsschicht (2) einen Brechungsindex von 1,60 oder mehr und weniger als 1,80 aufweist,

die zweite transparente Beschichtungsschicht (3) einen Brechungsindex von 1,30 bis 1,50 aufweist,

die transparente Elektrodenschicht (4) einen Brechungsindex von 1,80 bis 2,20 aufweist,

die erste transparente Beschichtungsschicht eine Dicke von 600 nm oder mehr und weniger als 1100 nm aufweist, und

die zweite transparente Beschichtungsschicht eine Dicke von 10 nm bis 100 nm aufweist.

7. Transparente leitfähige piezoelektrische Verbundfolie nach Anspruch 5 oder 6, wobei die transparente Elektrodenschicht eine Dicke von 7 nm oder mehr und weniger als 20 nm aufweist.

8. Transparente leitfähige piezoelektrische Verbundfolie nach Anspruch 5 oder 6, wobei der transparente piezoelektrische Folie ein Fluorharz als eine Hauptkomponente umfasst.

9. Transparente leitfähige piezoelektrische Verbundfolie nach Anspruch 5 oder 6, wobei die transparente Elektrodenschicht einen Brechungsindex von 1,94 oder weniger aufweist.

10. Transparente leitfähige piezoelektrische Verbundfolie nach Anspruch 5,
wobei

die transparente leitfähige piezoelektrische Verbundfolie die dritte transparente Beschichtungsschicht, die erste transparente Beschichtungsschicht, die zweite transparente Beschichtungsschicht und die transparente Elektrodenschicht umfasst, die in dieser Reihenfolge auf einer Oberfläche der transparenten leitfähigen piezoelektrischen Folie gestapelt sind, und

die transparente leitfähige piezoelektrische Verbundfolie eine weitere der dritten transparenten Beschichtungsschicht auf der anderen Oberfläche der transparenten leitfähigen piezoelektrischen Folie umfasst.

11. Transparente leitfähige piezoelektrische Verbundfolie nach Anspruch 6,
wobei

die transparente leitfähige piezoelektrische Verbundfolie die erste transparente Beschichtungsschicht, die zweite transparente Beschichtungsschicht und die transparente Elektrodenschicht umfasst, die in dieser Reihenfolge auf einer Oberfläche der transparenten leitfähigen piezoelektrischen Folie gestapelt sind,

die transparente leitfähige piezoelektrische Verbundfolie eine dritte transparente Beschichtungsschicht auf der anderen Oberfläche der transparenten leitfähigen piezoelektrischen Folie umfasst,

die dritte transparente Beschichtungsschicht einen Brechungsindex von 1,45 oder mehr und weniger als 1,60 aufweist, und

die dritte transparente Beschichtungsschicht eine Dicke von 500 nm bis 1400 nm aufweist.

12. Vorrichtung, umfassend die transparente leitfähige piezoelektrische Verbundfolie nach Anspruch 1.

13. Verfahren zum Herstellen einer transparenten leitfähigen piezoelektrischen Verbundfolie (11, 12), das ein Verfahren zum Herstellen einer Verbundfolie ist, bei dem eine erste transparente Beschichtungsschicht (2), eine zweite transparente Beschichtungsschicht (3) und eine transparente Elektrodenschicht (4) in dieser Reihenfolge auf mindestens einer Oberfläche einer transparenten piezoelektrischen Folie (1) gestapelt werden,
das Verfahren umfassend:

Herstellen der transparenten leitfähigen piezoelektrischen Folie, die eine Folie ausbildet, die einen Brechungsindex von 1,30 oder mehr und weniger als 1,45 aufweist,

Ausbilden der ersten transparenten Beschichtungsschicht, die einen Brechungsindex von 1,60 oder mehr und weniger als 1,80 auf mindestens einer Oberfläche der transparenten leitfähigen piezoelektrischen Folie aufweist,

Ausbilden der zweiten transparenten Beschichtungsschicht, die einen Brechungsindex von 1,30 oder mehr und weniger als 1,50 auf einer Oberfläche der ersten transparenten Beschichtungsschicht aufweist, und

Ausbilden der transparenten Elektrodenschicht, die einen Brechungsindex von 1,80 bis 2,20 auf einer Oberfläche der zweiten transparenten Beschichtungsschicht aufweist.

## EP 4 422 380 B1

**Revendications**

**1.** Film stratifié piézoélectrique conducteur transparent (11, 12) comprenant une couche d'électrode transparente (4) disposée sur un film piézoélectrique (1), dans lequel

le film piézoélectrique est un film constitué d'une résine,
**caractérisé en ce que** le film stratifié piézoélectrique conducteur transparent a une constante piézoélectrique $d_{31}$ allant de 10 pC/N à 40 pC/N et une transmittance totale de 90 % ou plus, et
un indice de jaune calculé par une méthode décrite dans la norme JIS K7373 à l'aide d'un système de couleur XYZ mesuré conformément à la norme JIS Z8722 est de 7 ou moins.

**2.** Film stratifié piézoélectrique conducteur transparent selon la revendication 1,
dans lequel

au moins une surface du film stratifié piézoélectrique conducteur transparent est formée de la couche d'électrode transparente, et
la surface a une valeur de résistance de surface de 300 Ω/carré ou plus et inférieure à 1 700 Ω/carré.

**3.** Film stratifié piézoélectrique conducteur transparent selon la revendication 2, dans lequel la valeur de résistance de surface est inférieure à 1 000 Ω/carré.

**4.** Film stratifié piézoélectrique conducteur transparent selon la revendication 1, dans lequel a* dans un système de couleurs L*a*b* mesuré conformément à la norme JIS Z8722 va de -1,5 à 1,0.

**5.** Film stratifié piézoélectrique conducteur transparent (12) selon la revendication 1,
dans lequel

le film stratifié piézoélectrique conducteur transparent comprend une troisième couche de revêtement transparente (5), une première couche de revêtement transparente (2),
une deuxième couche de revêtement transparente (3) et la couche d'électrode transparente (4) empilées dans cet ordre sur au moins une surface d'un film piézoélectrique transparent (1),
le film piézoélectrique transparent (1) a un indice de réfraction de 1,30 ou plus et inférieur à 1,45,
la troisième couche de revêtement transparente (5) a un indice de réfraction de 1,45 ou plus et inférieur à 1,60,
la première couche de revêtement transparente (2) a un indice de réfraction de 1,60 ou plus et inférieur à 1,80,
la deuxième couche de revêtement transparente (3) a un indice de réfraction de 1,30 à 1,50,
la couche d'électrode transparente (4) a un indice de réfraction de 1,80 à 2,20,
la première couche de revêtement transparente a une épaisseur de 60 nm ou plus et inférieure à 200 nm,
la deuxième couche de revêtement transparente a une épaisseur de 10 nm à 100 nm, et
la troisième couche de revêtement transparente a une épaisseur de 500 nm à 1 400 nm.

**6.** Film stratifié piézoélectrique conducteur transparent (11) selon la revendication 1,
dans lequel

le film stratifié piézoélectrique conducteur transparent comprend une première couche de revêtement transparente (2), une deuxième couche de revêtement transparente (3),
et la couche d'électrode transparente (4) empilées dans cet ordre sur au moins une surface d'un film piézoélectrique transparent (1),
le film piézoélectrique transparent (1) a un indice de réfraction de 1,30 ou plus et inférieur à 1,45,
la première couche de revêtement transparente (2) a un indice de réfraction de 1,60 ou plus et inférieur à 1,80,
la deuxième couche de revêtement transparente (3) a un indice de réfraction de 1,30 à 1,50,
la couche d'électrode transparente (4) a un indice de réfraction de 1,80 à 2,20,
la première couche de revêtement transparente a une épaisseur de 600 nm ou plus et inférieure à 1 100 nm, et
la deuxième couche de revêtement transparente a une épaisseur de 10 nm à 100 nm.

**7.** Film stratifié piézoélectrique conducteur transparent selon la revendication 5 ou 6, dans lequel la couche d'électrode transparente a une épaisseur de 7 nm ou plus et inférieure à 20 nm.

**8.** Film stratifié piézoélectrique conducteur transparent selon la revendication 5 ou 6, dans lequel le film piézoélectrique transparent comprend une résine fluorée comme composant principal.

9. Film stratifié piézoélectrique conducteur transparent selon la revendication 5 ou 6, dans lequel la couche d'électrode transparente a un indice de réfraction de 1,94 ou moins.

10. Film stratifié piézoélectrique conducteur transparent selon la revendication 5,
dans lequel

le film stratifié piézoélectrique conducteur transparent comprend la troisième couche de revêtement transparente, la première couche de revêtement transparente, la deuxième couche de revêtement transparente, et la couche d'électrode transparente empilées dans cet ordre sur une surface du film piézoélectrique transparent, et
le film stratifié piézoélectrique conducteur transparent comprend une autre parmi la troisième couche de revêtement transparente sur l'autre surface du film piézoélectrique transparent.

11. Film stratifié piézoélectrique conducteur transparent selon la revendication 6,
dans lequel

le film stratifié piézoélectrique conducteur transparent comprend la première couche de revêtement transparente, la deuxième couche de revêtement transparente, et la couche d'électrode transparente empilées dans cet ordre sur une surface du film piézoélectrique transparent,
le film stratifié piézoélectrique conducteur transparent comprend une troisième couche de revêtement transparente sur l'autre surface du film piézoélectrique transparent,
la troisième couche de revêtement transparente a un indice de réfraction de 1,45 ou plus et inférieur à 1,60, et
la troisième couche de revêtement transparente a une épaisseur de 500 nm à 1 400 nm.

12. Dispositif comprenant le film stratifié piézoélectrique conducteur transparent décrit dans la revendication 1.

13. Procédé de production d'un film stratifié piézoélectrique conducteur transparent (11, 12), étant un procédé de production d'un film stratifié dans lequel une première couche de revêtement transparente (2), une deuxième couche de revêtement transparente (3), et une couche d'électrode transparente (4) sont empilées dans cet ordre sur au moins une surface d'un film piézoélectrique transparent (1),
le procédé comprenant :

la production du film piézoélectrique transparent formant un film ayant un indice de réfraction de 1,30 ou plus et inférieur à 1,45,
la formation de la première couche de revêtement transparente ayant un indice de réfraction de 1,60 ou plus et inférieur à 1,80 sur au moins une surface du film piézoélectrique transparent,
la formation de la deuxième couche de revêtement transparente ayant un indice de réfraction de 1,30 ou plus et inférieur à 1,50 sur une surface de la première couche de revêtement transparente, et
la formation de la couche d'électrode transparente ayant un indice de réfraction de 1,80 à 2,20 sur une surface de la deuxième couche de revêtement transparente.

[FIG. 1]

[FIG. 2]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017074792 A

- US 20170033279 A1